# EUROPEAN PATENT SPECIFICATION

(11) **EP 3 961 852 B1**
(45) Date of publication and mention of the grant of the patent: **25.02.2026**
(21) Application number: 21194091.1
(22) Date of filing: 31.08.2021
(51) Int. Cl.: H02J 7/00, H01M 10/42, H01M 50/574

(54) **BATTERY PROTECTION CIRCUIT AND BATTERY APPARATUS INCLUDING THE SAME**
BATTERIESCHUTZSCHALTUNG UND BATTERIEGERÄT DAMIT
CIRCUIT DE PROTECTION DE BATTERIE ET APPAREIL DE BATTERIE L'INCLUANT

(30) Priority: 31.08.2020 KR 20200110373
(43) Date of publication of application: 02.03.2022
(73) Proprietor: Samsung SDI Co., Ltd., Yongin-si, Gyeonggi-do 17084 (KR)
(72) Inventor: JEONG, Hyeoncheol, 17084 Yongin-si (KR); LEE, Sanggu, 17084 Yongin-si (KR); JIN, Kyongpil, 17084 Yongin-si (KR)
(74) Representative: Marks & Clerk LLP

(56) References cited:
- EP-A1- 1 936 774
- US-A- 5 637 413
- US-A1- 2009 268 355

## Description

### BACKGROUND OF THE INVENTION

### (a) Field of the Invention

The present disclosure relates to a battery protection circuit and a battery apparatus including the same.

### (b) Description of the Related Art

Generally, a rechargeable battery that may be charged and discharged is combined with a circuit to configure a battery pack, and is charged and discharged through an outer terminal of the battery pack. When external power is connected through the outer terminal of the battery pack, a battery cell is charged by the external power supplied through the outer terminal and a charging/discharging circuit, and when the outer terminal and a load are connected, power of the battery cell is supplied to the load through the charging/discharging circuit and the outer terminal.

Meanwhile, various types of charging/discharging abnormalities may exist in the battery pack, such as an overcharging current due to an overvoltage charger connection and an overdischarging current flowing from the battery pack to the outside. Accordingly, a conventional battery pack is provided with a separate terminal for recognizing a dedicated charger. In addition, the conventional battery pack is provided with a protection circuit to block overcharging and overdischarging of the battery pack when the battery pack is abnormally charged or discharged.

When a switch is used in the protection circuit to control a connection between the battery pack and an external electronic device, a processor of a battery management system must continuously transmit a control signal to the switch so that the switch may be maintained in an on state. In this case, there is a problem that the switch may not be controlled when a fault occurs in the processor.

US5637413A shows an overvoltage disconnect circuit for a lithium-ion battery pack to protect it when charged by a charger designed for nickel-system batteries. The circuit is located within the battery pack.

US2009/268355A discusses a safety output device. The above information disclosed in this Background section is only for enhancement of understanding of the background of the invention, and therefore it may contain information that does not form the prior art that is already known in this country to a person of ordinary skill in the art.

### SUMMARY OF THE INVENTION

Embodiments have been made in an effort to provide a battery apparatus that may recognize a dedicated charger without a separate terminal. In addition, embodiments have been made in an effort to provide a battery apparatus that includes a protective circuit for preventing an overvoltage charger from being connected thereto. A battery protection circuit is set out in claim 1. Further aspects and preferred embodiments are set out in claim 2 et seq. A battery protection circuit may include: a voltage divider connected in parallel to an outer terminal; a controller that outputs an overvoltage determination signal when a voltage divided by the voltage divider is inputted thereto; a logic portion that outputs a switching control signal when the overvoltage determination signal and the divided voltage are inputted thereto; and a switching portion that controls a connection of a battery module and the outer terminal according to the switching control signal. The logic portion includes an AND gate and an inverter, the inverter receives the voltage divided by the voltage divider and transmits an inverter output signal to the AND gate, and the AND gate receives the overvoltage determination signal and the inverter output signal to output a switching control signal.

When the divided voltage is greater than or equal to a predetermined first voltage, the inverter output signal and the overvoltage determination signal may be low level signals.

The switching control signal may be a low level signal, and the switching portion may be opened.

When the divided voltage is less than a predetermined first voltage, the inverter output signal and the overvoltage determination signal may be high level signals.

The switching control signal may be a high level signal, and the switching portion may be closed.

When the divided voltage is inputted according to a predetermined time sequence, the controller may determine that an external device connected to the outer terminal is a dedicated charger, and may output the overvoltage determination signal so that the logic portion outputs a switching control signal for connecting the battery module and the outer terminal.

Another embodiment provides a battery module protecting method, including: receiving, by a voltage divider, a voltage from an outer terminal; outputting, by a controller, an overvoltage determination signal when a voltage divided by the voltage divider is inputted thereto; outputting, by a logic portion, a switching control signal when the voltage divided by the voltage divider and the overvoltage determination signal are inputted thereto; and controlling, by a switching portion, a connection of a battery module and the outer terminal according to the switching control signal.

The logic portion includes an AND gate and an inverter; and the outputting, by the logic portion, of the switching control signal includes: transmitting, by the inverter, an inverter output signal to the AND gate when the voltage divided by the voltage divider is inputted thereto; and outputting, by the AND gate, the switching control signal when the overvoltage determination signal and the inverter output signal are inputted thereto.

When the divided voltage is greater than or equal to a predetermined first voltage, the inverter output signal and the overvoltage determination signal may be low level signals.

The switching control signal may be a low level signal; and disconnecting, by the switching portion, a battery module and the outer terminal according to the switching control signal may be further included.

When the divided voltage is less than a predetermined first voltage, the inverter output signal and the overvoltage determination signal may be high level signals.

The switching control signal may be a high level signal; and connecting, by the switching portion, a battery module and the outer terminal according to the switching control signal may be further included.

The receiving, by the voltage divider, of the voltage from the outer terminal may include: receiving a voltage according to a predetermined time sequence from the outer terminal; and the outputting, by the controller, of the overvoltage determination signal may include determining, by the controller, that an external device connected to the outer terminal is a dedicated charger when the voltage divided by the voltage divider is inputted thereto according to a predetermined time sequence, and outputting, by the controller, the overvoltage determination signal so that the logic portion outputs a switching control signal for connecting the battery module and the outer terminal.

Another embodiment provides a battery apparatus, including: a battery module; an outer terminal configured to connect an external device to the battery module; and a battery protection circuit, wherein the battery protection circuit may include: a voltage divider connected in parallel to the outer terminal; a controller that outputs an overvoltage determination signal when a voltage divided by the voltage divider is inputted thereto; a logic portion that outputs a switching control signal when the overvoltage determination signal and the divided voltage are inputted thereto; and a switching portion that connects or disconnects a battery module and the outer terminal according to the switching control signal.

The battery apparatus according to the embodiment may protect a battery apparatus from an overcharge current flowing as an overvoltage charger is connected to the battery apparatus.

The battery apparatus according to the embodiment may protect a battery apparatus from an overcharge current even when a battery management system does not operate.

The battery apparatus according to the embodiment may recognize a dedicated charger without a separate terminal, so that there is no need to manufacture an additional circuit, thereby reducing costs.

At least some of the above and other features of the invention are set out in the claims.

### BRIEF DESCRIPTION OF THE DRAWINGS

FIG. 1 illustrates a block diagram of a battery charging/discharging system according to an embodiment.
FIG. 2 illustrates a battery apparatus according to an embodiment.
FIG. 3 illustrates a schematic circuit diagram of an overvoltage charging protection portion and a low voltage detection circuit portion of the battery apparatus according to an embodiment.

### DETAILED DESCRIPTION OF THE EMBODIMENTS

Hereinafter, embodiments disclosed in the present specification will be described in detail with reference to the accompanying drawings, and in the present specification, the same or similar constituent elements will be denoted by the same or similar reference numerals, and a redundant description thereof will be omitted. The terms "module" and "unit, portion, or part" representing constituent elements used in the following description are used only in order to make understanding of the specification easier, and thus, these terms do not have meanings or roles that distinguish them from each other by themselves.

In the present specification, it should be understood that the term "include", "comprise", "have", or "configure" indicates that a feature, a number, a step, an operation, a constituent element, a part, or a combination thereof described in the specification is present, but does not exclude a possibility of presence or addition of one or more other features, numbers, steps, operations, constituent elements, parts, or combinations, in advance.

Hereinafter, an embodiment of the present invention will be described in detail with reference to the accompanying drawings.

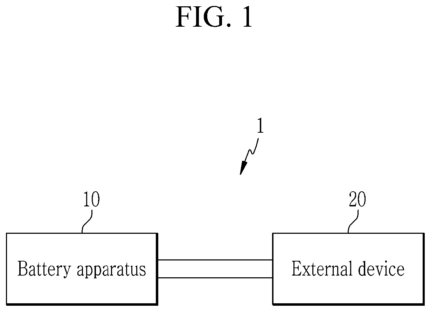

FIG. 1 schematically illustrates a block diagram of a battery charging/discharging system 1 according to an embodiment.

Referring to FIG. 1, the battery charging/discharging system 1 includes a battery apparatus 10 and an external device 20.

The battery apparatus 10 has a structure that may be electrically connected to the external device 20. When the external device 20 is a charger, the battery apparatus 10 receives external power through the charger 20 and is charged. When the external device 20 is a load, the battery apparatus 10 operates as a power supply that supplies power to the load 20 and is discharged.

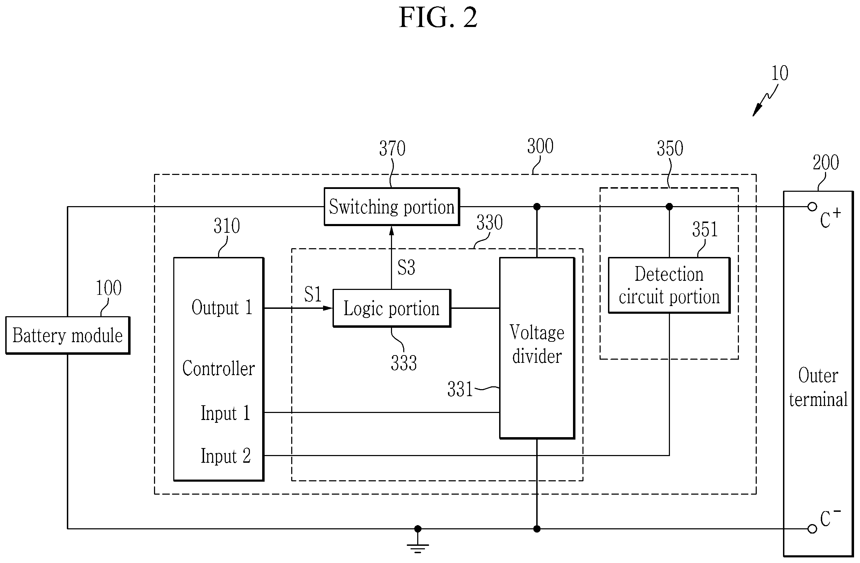

FIG. 2 illustrates the battery apparatus 10 according to the embodiment.

The battery apparatus 10 may include a battery module 100, an outer terminal 200, and a protection circuit 300.

The battery module 100 includes a plurality of battery cells (not shown). In some embodiments, each battery cell may be a rechargeable battery. A predetermined number of battery cells may be connected in series to configure a battery module.

The outer terminal 200 is a terminal for connecting the external device 20 to the battery apparatus 10.

The protection circuit 300 is a circuit for controlling a connection between the battery module 100 and the outer terminal 200. The protection circuit 300 prevents an overcharge current from flowing by blocking the battery module 100 from being charged when an overvoltage charger is connected to the outer terminal 200. In addition, the protection circuit 300 may block a current from being outputted from the battery module 100 when a low voltage load is connected to the outer terminal 200.

The protection circuit 300 may include a controller 310, an overvoltage charging protection portion 330, a low voltage detection circuit portion 350, and a switching portion 370.

The controller 310 may control an operation of the battery by acquiring basic data for checking a state of the battery apparatus 10. The controller 310 may control a connection between the battery module 100 and the outer terminal 200 to control charging and discharging of the battery module 100. For example, the controller 310 may output a signal for controlling the switching portion 370.

The overvoltage charging protection portion 330 may disconnect the battery module 10 and the outer terminal 200 by turning off the switching portion 370 to secure safety of the battery module 100 when the overvoltage charger is connected to the outer terminal 200.

The overvoltage charging protection portion 330 may include a voltage divider 331 and a logic portion 333.

One end of the voltage divider 331 is connected to a positive terminal (+) of the outer terminal 200 and the other end thereof is connected to a negative terminal (-) of the outer terminal 200. The voltage divider 331 divides a voltage inputted to the outer terminal 200 at a predetermined ratio to transmit the divided voltage to the controller 310 and the logic portion 333.

The controller 310 may output an overvoltage determination signal S1 to the logic portion 333 by comparing the voltage received from the voltage divider 331 with a predetermined overvoltage level voltage value therein. When the divided voltage is equal to or greater than the overvoltage level voltage value, the overvoltage determination signal S1 may be a disable signal. When the divided voltage is less than the overvoltage level voltage value, the overvoltage determination signal S1 may be an enable signal. Hereinafter, for ease of description, it is assumed that the enable signal is a high-level signal ("1") and the disable signal is a low-level signal ("0").

In addition, the controller 310 may store information on a dedicated charger according to a type of the battery module 100. For example, information about a method in which a dedicated charger of a battery module applies a voltage may be stored therein. When a voltage is inputted from the voltage divider 331 according to a predetermined time sequence, the controller 310 determines whether the time sequence of the inputted voltage is the same as that of the dedicated charger of the battery module 100 and recognizes that the external device 20 connected to the outer terminal 200 is a dedicated charger. In this case, the controller 310 may directly transmit a switching control signal for turning on the switching portion 370 to the switching portion 370.

The logic portion 333 may receive the overvoltage determination signal and the voltage divided by the voltage divider 331 to output a switching control signal S3.

When a low voltage is inputted to the outer terminal 200 due to noise and the like, the low voltage detection circuit portion 350 may prevent the controller 310 from waking up in order to reduce energy consumption of the battery module, thereby preventing the connection between the battery module 100 and the outer terminal 200.

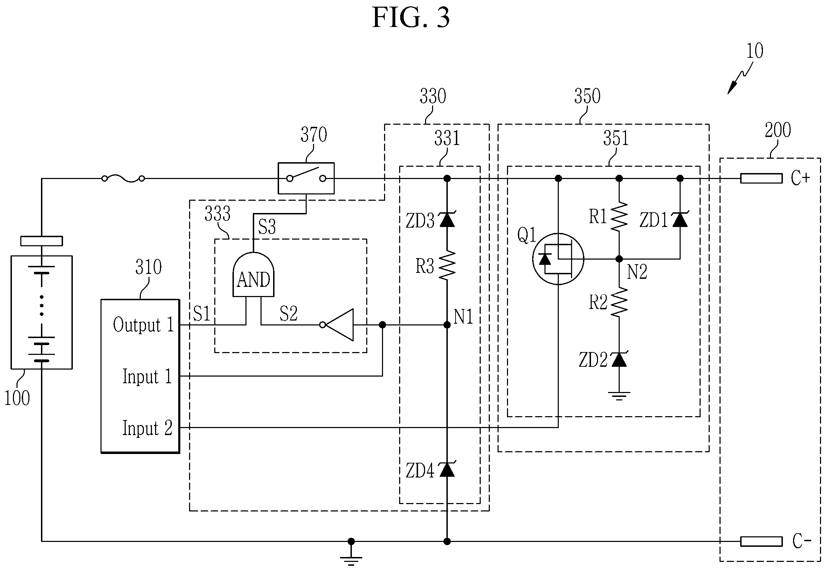

The low voltage detection circuit portion 350 may include a detection circuit portion 351. The detection circuit portion 351 may include a transistor (Q1 as shown in FIG. 3) operating based on a predetermined low voltage level voltage value.

The switching portion 370 is connected in series between the battery module 100 and the outer terminal 200 to control the electrical connection between the battery module 100 and the outer terminal 200. For example, the switching portion 370 may be connected between a positive output terminal to which the positive voltage of the battery module 100 is outputted and a positive connection terminal C(+) connected to the external device 20. The switching portion 370 is controlled by at least one of a signal transmitted from the controller 310 and the switching control signal S3 outputted from the logic portion 333.

FIG. 3 illustrates a schematic circuit diagram of the overvoltage charging protection portion 330 and the low voltage detection circuit portion 350 of the battery apparatus according to the embodiment.

The voltage divider 331 may include at least two Zener diodes ZD3 and ZD4 and a resistor R3. The at least two Zener diodes ZD3 and ZD4 and the resistor R3 may be connected in series between the outer terminal 200 and the ground. The voltage divider 331 may adjust respective values of the at least two Zener diodes ZD3 and ZD4 and the resistor R3 to determine a voltage division ratio. The voltage divider 331 may transmit a voltage of a node N1 between the resistor R3 and the Zener diode ZD4, that is, a voltage divided at a predetermined rate, to the logic portion 333.

The logic portion 333 may include an inverter and an AND gate.

The inverter outputs an inverter output signal S2 according to the voltage divided by the voltage divider 333. When a voltage inputted to the inverter is equal to and greater than a predetermined overvoltage level voltage value, it may output a disable signal. In addition, when the voltage inputted to the inverter is less than the predetermined overvoltage level voltage value, it may output an enable signal. Hereinafter, for ease of description, it is assumed that the disable signal of the inverter output signal S2 is a low-level signal ("0") and the enable signal thereof is a high-level signal "1". Here, the enable signal of the overvoltage determination signal S1 of the controller 310 and the enable signal of the inverter output signal S2 may be the same level signal, for example, a high level signal, and the disable signal of the overvoltage determination signal S1 and the disable signal of the inverter output signal S2 may also be the same level signal, for example, a low level signal.

The AND gate is a logic element that performs logical multiplication. The AND gate outputs the switching control signal S3 by performing a logical product between the overvoltage determination signal S1 from the controller 310 and the inverter output signal S2. The output S3 of the AND gate is shown in Table 1.

**(Table 1)**

| S1 | S2 | S3 |
|---|---|---|
| 0 | 0 | 0 |
| 0 | 1 | 0 |
| 1 | 0 | 0 |
| 1 | 1 | 1 |

The switching portion 370 may be opened or closed by the switching control signal S3 outputted from the logic portion 333. For example, when the switching control signal S3 is a high level signal ("1"), the switching portion 370 may be closed so that the battery module 100 and the outer terminal 200 may be connected. On the other hand, when the switching control signal S3 is a low level signal ("0"), the switching portion 370 may be opened so that the battery module 100 and the outer terminal 200 may not be connected.

The detection circuit portion 351 may include at least two Zener diodes ZD1 and ZD2, resistors R1 and R2, and the transistor Q1. Here, the resistor R1, the resistor R2, and the Zener diode ZD2 may be connected in series between the outer terminal 200 and the ground. The Zener diode ZD1 may be connected between a node N2 between the resistor R1 and the resistor R2 and the outer terminal 200. In addition, the transistor Q1 may be connected between the outer terminal 200 and the controller 310, and may be controlled by the voltage of the node N2.

Hereinafter, the operation of the overvoltage charging protection portion 330 will be described in detail with reference to FIG. 3.

In the overvoltage charging protection portion 330, a voltage Vz(ZD4) of the node N1 is inputted to an input terminal (input 1) of the controller 310 and to the inverter. When the Vz(ZD4) is greater than or equal to a predetermined overvoltage level voltage value, the controller 310 may output the overvoltage determination signal S1 of a low level through an output terminal (output 1). When the Vz(ZD4) is greater than or equal to the predetermined overvoltage level voltage value, the inverter may also output the inverter output signal S2 of a low level. In this case, the logic portion 333 may output the switching control signal S3 of a low level.

When the voltage Vz(ZD4) of the node N1 is less than a predetermined overvoltage level voltage value, the controller 310 may output the overvoltage determination signal S1 of a high level through the output terminal (output 1). When the Vz(ZD4) is less than the predetermined overvoltage level voltage value, the inverter may also output the inverter output signal S2 of a high level. In this case, the logic portion 333 may output the switching control signal S3 of a high level.

When the voltage inputted to the outer terminal 200 is A(V) and A(V)≥Vz(ZD3)+Vz(ZD4), the Vz(ZD4) is greater than or equal to the predetermined overvoltage level voltage value. Accordingly, both the overvoltage determination signal S1 and the inverter output signal S2 of the controller 330 are low level signals. Accordingly, since the logic portion 333 outputs the low level switching control signal S3, the switching unit 370 is not closed. Even if the controller 310 does not properly operate, since the inverter output signal S2 is a low level signal, the logic portion 333 outputs the low level switching control signal S3 regardless of the overvoltage determination signal S1. Accordingly, the switching portion 370 is not closed.

On the other hand, when the voltage inputted to the outer terminal 200 is A(V) and A(V)<Vz(ZD3)+Vz(ZD4), the Vz(ZD4) is less than the overvoltage level voltage value. Accordingly, both the overvoltage determination signal S1 and the inverter output signal S2 of the controller 330 are high level signals. Accordingly, since the logic portion 333 outputs the high level switching control signal S3, the switching portion 370 is closed, so the battery module 100 and the outer terminal 200 are connected to each other.

When the dedicated charger of the battery module 100 is connected to the outer terminal 200, the dedicated charger inputs a voltage thereto at a predetermined time sequence. When the voltage is inputted to the input terminal (input 1) at the predetermined time sequence, the controller 310 may recognize that the external device 20 connected to the outer terminal 200 is the dedicated charger 20, and may directly transmit a switching control signal for turning on the switching portion 370 to the switching portion 370. For example, when periods for maintaining the overvoltage level voltage value or more and periods for maintaining one less than the overvoltage level voltage value are alternately inputted three or more times, the controller 310 determines that the dedicated charger of the battery module 100 is connected. Accordingly, the controller 310 may directly transmit a switching control signal for turning on the switching portion 370 to the switching portion 370.

Here, it has been described that the reference voltages used as the threshold for the inverter and the controller 310 to detect the overvoltage state have the same reference as the overvoltage level voltage value, and the reference voltages may have different values.

Hereinafter, an operation of the low voltage detection circuit portion 350 will be described in detail with reference to FIG. 3.

A low voltage may be inputted to the outer terminal 200 of the battery apparatus 10 by noise, for example, from a human hand. In this case, the inputted voltage is referred to as B(V), and a breakdown voltage of the transistor Q1 of the detection circuit portion 351 is referred to as Vth(Q1). Then, a voltage of the node N2, that is, a voltage applied to a gate of the transistor Q1 is {B(V)-Vz(ZD2)} x R1 ÷ (R2+R1).

When a breakdown voltage Vth(Q1) of the transistor Q1 is greater than the voltage of the node N2, that is, when the voltage inputted to the outer terminal 200 is higher than a predetermined low voltage level voltage value, the transistor Q1 is turned on, so that a current flows from the outer terminal 200 to the input terminal (input 2) of the controller 310, and a wake-up signal is transmitted to the controller 310. Accordingly, the controller 310 may output a switching control signal according to the voltage B(V) inputted to the outer terminal 200.

On the other hand, when the breakdown voltage Vth(Q1) of the transistor Q1 is smaller than a voltage applied to the gate thereof, that is, when the voltage inputted to the outer terminal 200 is lower than the predetermined low voltage level voltage value, the transistor Q1 is not turned on, the wake-up signal is not transmitted to the input terminal (input 2) of the controller 310, and the controller 310 does not operate.

The overvoltage charging protection portion 330 and the low voltage detection circuit portion 350 according to the above-described embodiments may be mounted on a single printed circuit board (PCB) to be combined with the battery module, and they may be respectively mounted on a separate printed circuit board to be combined with the battery module.

According to the battery apparatus according to the present disclosure, it is possible to protect a battery apparatus from an overcharge current flowing as an overvoltage charger is connected to the battery apparatus.

According to the battery apparatus according to the present disclosure, it is possible to protect a battery apparatus from an overcharge current even when a battery management system does not operate.

According to the battery apparatus according to the present disclosure, it is possible to recognize a dedicated charger without a separate terminal, so that there is no need to manufacture an additional circuit, thereby reducing costs.

The steps constituting the method according to the embodiments may be performed in an appropriate order unless explicitly stated or contradicted by the order. In the present invention, use of all examples or illustrative terms (e.g., etc.) is merely for describing the present invention in details. In addition, a person of ordinary skill in the art can recognize that various modifications, combinations, and changes may be made within the scope of the appended claims.

While this invention has been described in connection with what is presently considered to be practical embodiments, it is to be understood that the invention is not limited to the disclosed embodiments, but, on the contrary, is intended to cover various modifications and equivalent arrangements included within the scope of the appended claims.

## Claims

1. A battery protection circuit (300) of a battery apparatus (10), comprising:
a voltage divider (331) configured to be connected in parallel to an outer terminal (200) of the battery apparatus;
a controller (310) that outputs an overvoltage determination signal, S1, when a divided voltage is inputted from the voltage divider to the controller;
a logic portion (333) that outputs a switching control signal, S3, when the overvoltage determination signal and the divided voltage are inputted thereto; and
a switching portion (370) configured to control a connection of a battery module (100) of the battery apparatus (10) and the outer terminal according to the switching control signal,
wherein
the logic portion (333) includes an AND gate and an inverter,
the inverter receives the voltage divided by the voltage divider and transmits an inverter output signal, S2, to the AND gate, and
the AND gate receives the overvoltage determination signal, S1, and the inverter output signal to output a switching control signal, S3.

2. The battery protection circuit of claim 1, configured such that when the divided voltage is greater than or equal to a predetermined first voltage,
the inverter output signal, S2, and the overvoltage determination signal, S1, are low level signals.

3. The battery protection circuit of any of claims 1 and 2, configured such that
when the switching control signal, S3, is a low level signal,
the switching portion is opened (370).

4. The battery protection circuit of claim 1, configured such that
when the divided voltage is less than a predetermined first voltage,
the inverter output signal, S2, and the overvoltage determination signal, S1, are high level signals.

5. The battery protection circuit of any preceding claim, configured such that
when the switching control signal, S3, is a high level signal,
the switching portion is closed (370).

6. The battery protection circuit of any preceding claim, configured such that
when the divided voltage from the voltage divider is inputted to the controller according to a predetermined time sequence,
the controller (310) determines that an external device (20) connected to the outer terminal (200) is a dedicated charger, and outputs the overvoltage determination signal, S1, so that the logic portion (333) outputs a switching control signal, S3, for connecting the battery module (100) and the outer terminal.

7. A battery module protecting method, comprising:
receiving, by a voltage divider (331), a voltage from an outer terminal (200) of a battery apparatus (10);
outputting, by a controller (310), an overvoltage determination signal, S1, when a voltage divided by the voltage divider is inputted thereto;
outputting, by a logic portion (333), a switching control signal, S3, when the voltage divided by the voltage divider and the overvoltage determination signal are inputted thereto; and
controlling, by a switching portion (370), a connection of a battery module (100) of the battery apparatus and the outer terminal according to the switching control signal,
wherein
the logic portion (333) includes an AND gate and an inverter; and
the outputting, by the logic portion, of the switching control signal includes
transmitting, by the inverter, an inverter output signal, S2, to the AND gate when the voltage divided by the voltage divider (331) is inputted thereto, and
outputting, by the AND gate, the switching control signal, S3, when the overvoltage determination signal, S1, and the inverter output signal are inputted thereto.

8. The battery module protecting method of claim 7, wherein
when the divided voltage is greater than or equal to a predetermined first voltage,
the inverter output signal, S2, and the overvoltage determination signal, S1, are low level signals.

9. The battery module protecting method of any of claims 7 or 8, wherein
when the switching control signal, S3, is a low level signal, the method comprises
disconnecting, by the switching portion (370), a battery module (100) and the outer terminal (200) according to the switching control signal.

10. The battery module protecting method of claim 7, wherein
when the divided voltage is less than a predetermined first voltage,
the inverter output signal, S2, and the overvoltage determination signal, S3, are high level signals.

11. The battery module protecting method of any of claims 7 to 10, wherein
when the switching control signal, S3, is a high level signal, the method comprises
connecting, by the switching portion (370), a battery module (100) and the outer terminal (200) according to the switching control signal.

12. The battery module protecting method of any of claims 7 to 11, wherein
the receiving, by the voltage divider (331), the voltage from the outer terminal (200) includes
receiving a voltage according to a predetermined time sequence from the outer terminal; and
the outputting, by the controller (310), of the overvoltage determination signal, S1, includes
determining, by the controller, that an external device (20) connected to the outer terminal is a dedicated charger when the voltage divided by the voltage divider is inputted thereto according to a predetermined time sequence, and
outputting, by the controller, the overvoltage determination signal so that the logic portion (333) outputs a switching control signal, S3, for connecting the battery module and the outer terminal.

13. A battery apparatus (10), comprising:
a battery module (100);
an outer terminal (200) configured to connect an external device (20) to the battery module; and
a battery protection circuit (300) in accordance with any of claims 1 to 6, wherein the switching portion (370) connects or disconnects the battery module and the outer terminal according to the switching control signal, S3.

## Patentansprüche

1. Batterieschutzschaltung (300) einer Batterieeinrichtung (10), umfassend:
einen Spannungsteiler (331), der konfiguriert ist, parallel mit einem äußeren Anschluss (200) der Batterieeinrichtung verbunden zu werden;
eine Steuereinheit (310), die ein Überspannungsbestimmungssignal, S1, ausgibt, wenn eine geteilte Spannung vom Spannungsteiler in die Steuereinheit eingegeben wird;
ein Logikteil (333), das ein Schaltsteuersignal, S3, ausgibt, wenn das Überspannungsbestimmungssignal und die geteilte Spannung eingegeben werden; und
ein Schaltteil (370), das so konfiguriert ist, dass es eine Verbindung eines Batteriemoduls (100) der Batterieeinrichtung (10) und des äußeren Anschlusses gemäß dem Schaltsteuersignal steuert,
wobei
das Logikteil (333) ein UND-Gatter und einen Wechselrichter beinhaltet,
der Wechselrichter die durch den Spannungsteiler geteilte Spannung empfängt und ein Wechselrichter-Ausgangssignal, S2, an das UND-Gatter sendet, und
das UND-Gatter das Überspannungsbestimmungssignal, S1, und das Wechselrichter-Ausgangssignal empfängt, um ein Schaltsteuersignal, S3, auszugeben.

2. Batterieschutzschaltung nach Anspruch 1, die so konfiguriert ist, dass, wenn die geteilte Spannung größer oder gleich einer vorbestimmten ersten Spannung ist,
das Wechselrichter-Ausgangssignal, S2, und das Überspannungsbestimmungssignal, S1, Signale mit niedrigem Pegel sind.

3. Batterieschutzschaltung nach einem der Ansprüche 1 oder 2, die so konfiguriert ist, dass
wenn das Schaltsteuersignal, S3, ein Signal mit niedrigem Pegel ist,
das Schaltteil geöffnet ist (370).

4. Batterieschutzschaltung nach Anspruch 1, die so konfiguriert ist, dass
wenn die geteilte Spannung kleiner als eine vorbestimmte erste Spannung ist,
das Wechselrichter-Ausgangssignal, S2, und das Überspannungsbestimmungssignal, S1, Signale mit hohem Pegel sind.

5. Batterieschutzschaltung nach einem vorstehenden Anspruch, die so konfiguriert ist, dass
wenn das Schaltsteuersignal, S3, ein Signal mit hohem Pegel ist,
das Schaltteil geschlossen ist (370).

6. Batterieschutzschaltung nach einem vorstehenden Anspruch, die so konfiguriert ist, dass
wenn die geteilte Spannung vom Spannungsteiler gemäß einer vorbestimmten Zeitfolge in die Steuereinheit eingegeben wird,
die Steuereinheit (310) bestimmt, dass eine externe Vorrichtung (20), die mit dem äußeren Anschluss (200) verbunden ist,ein dediziertes Ladegerät ist, und das Überspannungsbestimmungssignal, S1, ausgibt, sodass das Logikteil (333) ein Schaltsteuersignal, S3, ausgibt, um das Batteriemodul (100) mit dem äußeren Anschluss zu verbinden.

7. Batteriemodulschutzverfahren, umfassend:
Empfangen einer Spannung von einem äußeren Anschluss (200) einer Batterieeinrichtung (10) durch einen Spannungsteiler (331);
Ausgeben eines Überspannungsbestimmungssignals, S1, durch eine Steuereinheit (310), wenn eine durch den Spannungsteiler geteilte Spannung darin eingegeben wird;
Ausgeben eines Schaltsteuersignals, S3, durch ein Logikteil (333), wenn die durch den Spannungsteiler geteilte Spannung und das Überspannungsbestimmungssignal darin eingegeben werden; und
Steuern, durch ein Schaltteil (370), einer Verbindung eines Batteriemoduls (100) der Batterieeinrichtung mit dem äußeren Anschluss gemäß dem Schaltsteuersignal,
wobei
das Logikteil (333) ein UND-Gatter und einen Wechselrichter beinhaltet; und
das Ausgeben des Schaltsteuersignals durch das Logikteil beinhaltet
Senden, durch den Wechselrichter, eines Wechselrichter-Ausgangssignals, S2, an das UND-Gatter, wenn die durch den Spannungsteiler (331) geteilte Spannung darin eingegeben wird, und
Ausgeben, durch das UND-Gatter, des Schaltsteuersignals, S3, wenn das Überspannungsbestimmungssignal, S1, und das Wechselrichter-Ausgangssignal darin eingegeben werden.

8. Batteriemodulschutzverfahren nach Anspruch 7, wobei
wenn die geteilte Spannung größer oder gleich einer vorbestimmten ersten Spannung ist,
das Wechselrichter-Ausgangssignal, S2, und das Überspannungsbestimmungssignal, S1, Signale mit niedrigem Pegel sind.

9. Batteriemodulschutzverfahren nach einem der Ansprüche 7 oder 8, wobei
wenn das Schaltsteuersignal, S3, ein Signal mit niedrigem Pegel ist, das Verfahren umfasst
Trennen, durch das Schaltteil (370), eines Batteriemoduls (100) und des äußeren Anschlusses (200) gemäß dem Schaltsteuersignal.

10. Batteriemodulschutzverfahren nach Anspruch 7, wobei
wenn die geteilte Spannung kleiner als eine vorbestimmte erste Spannung ist,
das Wechselrichter-Ausgangssignal, S2, und das Überspannungsbestimmungssignal, S3, Signale mit hohem Pegel sind.

11. Batteriemodulschutzverfahren nach einem der Ansprüche 7 bis 10, wobei
wenn das Schaltsteuersignal, S3, ein Signal mit hohem Pegel ist, das Verfahren umfasst
Verbinden eines Batteriemoduls (100) und des äußeren Anschlusses (200) durch das Schaltteil (370) gemäß dem Schaltsteuersignal.

12. Batteriemodulschutzverfahren nach einem der Ansprüche 7 bis 11, wobei
das Empfangen, durch den Spannungsteiler (331), der Spannung vom äußeren Anschluss (200) beinhaltet
Empfangen einer Spannung gemäß einer vorbestimmten Zeitfolge vom äußeren Anschluss; und
das Ausgeben des Überspannungsbestimmungssignals, S1, durch die Steuereinheit (310) beinhaltet
Bestimmen, durch die Steuereinheit, dass eine externe Vorrichtung (20), die mit dem äußeren Anschluss verbunden ist, ein dediziertes Ladegerät ist, wenn die durch den Spannungsteiler geteilte Spannung gemäß einer vorbestimmten Zeitfolge darin eingegeben wird, und
Ausgeben, durch die Steuereinheit, des Überspannungsbestimmungssignals, sodass das Logikteil (333) ein Schaltsteuersignal, S3, ausgibt, um das Batteriemodul mit dem äußeren Anschluss zu verbinden.

13. Batterieeinrichtung (10), umfassend:
ein Batteriemodul (100);
einen äußeren Anschluss (200), der konfiguriert ist, eine externe Vorrichtung (20) mit dem Batteriemodul zu verbinden; und
eine Batterieschutzschaltung (300) nach einem der Ansprüche 1 bis 6,
wobei das Schaltteil (370) das Batteriemodul und den äußeren Anschluss gemäß dem Schaltsteuersignal, S3, verbindet oder trennt.

## Revendications

1. Circuit de protection de batterie (300) d'un appareil à batterie (10), comprenant :
un diviseur de tension (331) configuré pour être connecté en parallèle à une borne extérieure (200) de l'appareil de batterie ;
un dispositif de commande (310) qui produit un signal de détermination de surtension, S1, lorsqu'une tension divisée est entrée du diviseur de tension au dispositif de commande ;
une partie logique (333) qui génère un signal de commande de commutation, S3, lorsque le signal de détermination de surtension et la tension divisée lui sont appliqués ; et
une partie de commutation (370) configurée pour commander une connexion d'un module de batterie (100) de l'appareil de batterie (10) et la borne extérieure selon le signal de commande de commutation,
dans lequel
la partie logique (333) inclut une porte ET et un inverseur,
l'onduleur reçoit la tension divisée par le diviseur de tension et transmet un signal de sortie d'onduleur, S2, à la porte ET, et
la porte ET reçoit le signal de détermination de surtension, S1, et le signal de sortie de l'onduleur pour produire un signal de commande de commutation, S3.

2. Circuit de protection de batterie selon la revendication 1, configuré de telle sorte que lorsque la tension divisée est supérieure ou égale à une première tension prédéterminée,
le signal de sortie de l'onduleur, S2, et le signal de détermination de surtension, S1, sont des signaux de niveau bas.

3. Circuit de protection de batterie selon l'une quelconque des revendications 1 et 2, configuré de telle sorte que
lorsque le signal de commande de commutation, S3, est un signal de niveau bas,
la partie de commutation est ouverte (370).

4. Circuit de protection de batterie selon la revendication 1, configuré de telle sorte que
lorsque la tension divisée est inférieure à une première tension prédéterminée,
le signal de sortie de l'onduleur, S2, et le signal de détermination de surtension, S1, sont des signaux de niveau haut.

5. Circuit de protection de la batterie de toute revendication précédente, configuré de telle sorte que
lorsque le signal de commande de commutation, S3, est un signal de niveau haut,
la partie de commutation est fermée (370).

6. Circuit de protection de la batterie de toute revendication précédente, configuré de telle sorte que
lorsque la tension divisée provenant du diviseur de tension est appliquée au dispositif de commande selon une séquence temporelle prédéterminée,
le dispositif de commande (310) détermine qu'un dispositif externe (20) connecté à la borne extérieure (200) est un chargeur dédié et émet le signal de détermination de surtension, S1, afin que la partie logique (333) émette un signal de commande de commutation, S3, pour connecter le module de batterie (100) et la borne extérieure.

7. Procédé de protection d'un module de batterie, comprenant :
la réception, par un diviseur de tension (331), d'une tension provenant d'une borne extérieure (200) d'un appareil à batterie (10) ;
l'émission, par un dispositif de commande (310), d'un signal de détermination de surtension, S1, lorsqu'une tension divisée par le diviseur de tension lui est appliquée ;
la production, par une partie logique (333), d'un signal de commande de commutation, S3, lorsque la tension divisée par le diviseur de tension et le signal de détermination de surtension y sont appliqués ; et
la commande, par une partie de commutation (370), d'une connexion d'un module de batterie (100) de l'appareil de batterie et de la borne extérieure selon le signal de commande de commutation,
dans lequel
la partie logique (333) inclut une porte ET et un inverseur ; et
la sortie, par la partie logique, du signal de commande de commutation inclut
la transmission, par l'inverseur, d'un signal de sortie d'inverseur, S2, à la porte ET lorsque la tension divisée par le diviseur de tension (331) y est appliquée, et
la production, par la porte ET, du signal de commande de commutation, S3, lorsque le signal de détermination de surtension, S1, et le signal de sortie de l'onduleur y sont entrés.

8. Procédé de protection du module de batterie selon la revendication 7, dans lequel
lorsque la tension divisée est supérieure ou égale à une première tension prédéterminée,
le signal de sortie de l'onduleur, S2, et le signal de détermination de surtension, S1, sont des signaux de niveau bas.

9. Procédé de protection du module de batterie selon l'une quelconque des revendications 7 ou 8, dans lequel
lorsque le signal de commande de commutation, S3, est un signal de niveau bas, le procédé comprend
la déconnexion, par la partie de commutation (370), d'un module de batterie (100) et de la borne extérieure (200) selon le signal de commande de commutation.

10. Procédé de protection du module de batterie selon la revendication 7, dans lequel
lorsque la tension divisée est inférieure à une première tension prédéterminée,
le signal de sortie de l'onduleur, S2, et le signal de détermination de surtension, S3, sont des signaux de niveau haut.

11. Procédé de protection du module de batterie selon l'une quelconque des revendications 7 à 10, dans lequel
lorsque le signal de commande de commutation, S3, est un signal de niveau haut, le procédé comprend
la connexion, par la partie de commutation (370), d'un module de batterie (100) et de la borne extérieure (200) selon le signal de commande de commutation.

12. Procédé de protection du module de batterie selon l'une quelconque des revendications 7 à 11, dans lequel
la réception, par le diviseur de tension (331), de la tension provenant de la borne extérieure (200) inclut
la réception d'une tension selon une séquence temporelle prédéterminée de la borne extérieure ; et
la sortie, par le dispositif de commande (310), du signal de détermination de surtension, S1, inclut
la détermination, par le dispositif de commande, qu'un dispositif externe (20) connecté à la borne extérieure est un chargeur dédié lorsque la tension divisée par le diviseur de tension y est appliquée selon une séquence temporelle prédéterminée, et
la production, par le dispositif de commande, du signal de détermination de surtension afin que la partie logique (333) produise un signal de commande de commutation, S3, pour connecter le module de batterie et la borne extérieure.

13. Appareil à batterie (10), comprenant :
un module de batterie (100) ;
un terminal extérieur (200) configuré pour connecter un dispositif externe (20) au module de batterie ; et
un circuit de protection de batterie (300) conformément à l'une quelconque des revendications 1 à 6,
dans lequel la partie de commutation (370) connecte ou déconnecte le module de batterie et la borne extérieure en fonction du signal de commande de commutation, S3.
